# FASCICULE DE BREVET EUROPEEN

(11) **EP 2 533 621 B1**
(45) Date de publication et mention de la délivrance du brevet: **31.07.2019**
(21) Numéro de dépôt: 12171043.8
(22) Date de dépôt: 06.06.2012
(51) Int. Cl.: F28D 15/00, F28D 1/02, H05K 7/20, F28D 21/00

(54) **Système de refroidissement à eau déionisée pour équipement électrique**
Kühlsystem mit entionisiertem Wasser für Elektrogerät
Cooling system with deionised water for electrical equipment

(30) Priorité: 07.06.2011 FR 1154937
(43) Date de publication de la demande: 12.12.2012
(73) Titulaire: GE Energy Power Conversion Technology Limited, Rugby Warwickshire CV21 1BU (GB)
(72) Inventeur: Baerd, Henri, 77430 Champagne sur Seine (FR); Godfroy, Guillaume, 78000 Versailles (FR)
(74) Mandataire: Serjeants LLP

(56) Documents cités:
- WO-A1-2008/055515
- CN-U- 201 584 884
- US-A1- 2009 211 736

## Description

La présente invention concerne un système de refroidissement à eau déionisée pour un équipement électrique, du type décrit dans le préambule de la revendication 1.

L'invention s'applique en particulier aux équipements électroniques et électrotechniques sous-marins, protégés dans des enceintes étanches pour des profondeurs de 0 à environ 6 000 mètres, en particulier des systèmes de transmission ou de distribution, ainsi que des convertisseurs de puissance typiquement de 100 kVA à plusieurs centaines de MVA.

De tels équipements doivent en général être refroidis. Une méthode de refroidissement connue consiste à faire circuler dans l'équipement en question de l'eau déionisée et refroidie. La circulation de l'eau est assurée par des pompes requérant une puissance électrique significative, de l'ordre de 5 à 30 kVA.

Ces pompes sont alimentées en puissance électrique par un système d'alimentation externe à l'équipement en question. Afin de maintenir un niveau de déionisation approprié dans le circuit d'eau de refroidissement, l'alimentation des pompes doit se faire en fonctionnement normal de l'équipement à refroidir, c'est-à-dire lorsque ce dernier est sous tension et alimenté par le réseau de puissance, mais aussi lorsque que cet équipement est à l'arrêt et hors tension. En effet, la mise sous tension de l'équipement n'est en général autorisée que si le niveau de déionisation de l'eau de refroidissement est suffisant.

US 2009/211736 divulgue un appareil pour faire circuler un fluide de refroidissement dans un dispositif électrique ou électronique, l'appareil n'étant pas à eau déionisée.

WO 2008/055515 divulgue une installation sous-marine comportant un variateur de vitesse et un convertisseur de courant refroidi par des fluides d'isolation électrique. Le refroidissement se fait par convexion naturelle ou forcée, l'appareil n'étant pas à eau déionisée.

CN 201584884 représente l'état de la technique le plus proche. Il décrit, d'après son abrégé, un système de refroidissement comportant un groupe de pompage principal et un circuit de déionisation d'eau, conformément au préambule de la revendication 1.

Un but de l'invention est de fournir un système de refroidissement à eau déionisée dont l'alimentation en puissance auxiliaire présente une consommation électrique relativement peu importante lorsque l'équipement à refroidir est à l'arrêt.

A cet effet, l'invention a pour objet un système de refroidissement à eau déionisée pour équipement électrique du type précité, caractérisé par la partie caractérisante de la revendication 1.

Selon des modes particuliers de réalisation, le système de refroidissement peut comprendre l'une ou plusieurs des caractéristiques des revendications 2 à 4 prise(s) isolément ou selon toutes les combinaisons techniquement possibles.

L'invention concerne aussi une installation électrique caractérisée en ce qu'elle comprend :
- un équipement électrique destiné à être alimenté en puissance électrique par une alimentation primaire ; et
- un système de refroidissement à eau déionisée tel que décrit ci-dessus pour refroidir l'équipement électrique.

Selon des modes particuliers de réalisation, l'installation électrique peut comprendre l'une ou plusieurs des caractéristiques des revendications 6 à 10, prise(s) isolément ou selon toutes les combinaisons techniquement possibles.

L'invention concerne enfin un procédé de refroidissement d'une installation électrique telle que décrite ci-dessus, caractérisé en ce qu'il comprend les étapes suivantes :
- l'équipement électrique étant en fonctionnement, alimentation en puissance électrique du groupe de pompage principal du système de refroidissement par la source de puissance principale de manière à faire circuler l'eau déionisée dans le circuit principal et le circuit de déionisation du système de refroidissement ; et
- l'équipement électrique étant à l'arrêt, alimentation en puissance électrique du groupe de pompage secondaire du système de refroidissement par la source de puissance secondaire pour faire circuler l'eau déionisée dans au moins une portion du circuit de déionisation comprenant le déionisateur et dans le circuit principal.

Selon un mode particulier de réalisation, l'installation électrique peut comprendre la caractéristique suivante :
- à l'étape d'alimentation en puissance électrique du groupe de pompage principal, le groupe de pompage secondaire est à l'arrêt et à l'étape d'alimentation en puissance électrique du groupe de pompage secondaire, le groupe de pompage principal est à l'arrêt.

L'invention sera mieux comprise à la lecture de la description qui va suivre, donnée uniquement à titre d'exemple, et faite en se référant aux dessins annexés, sur lesquels :
- la figure 1 est une vue schématique partielle d'une installation selon l'invention, cette vue insistant sur les aspects hydrauliques,
- la figure 2 est une vue schématique partielle d'une installation selon l'invention, cette vue insistant sur les aspects électriques.

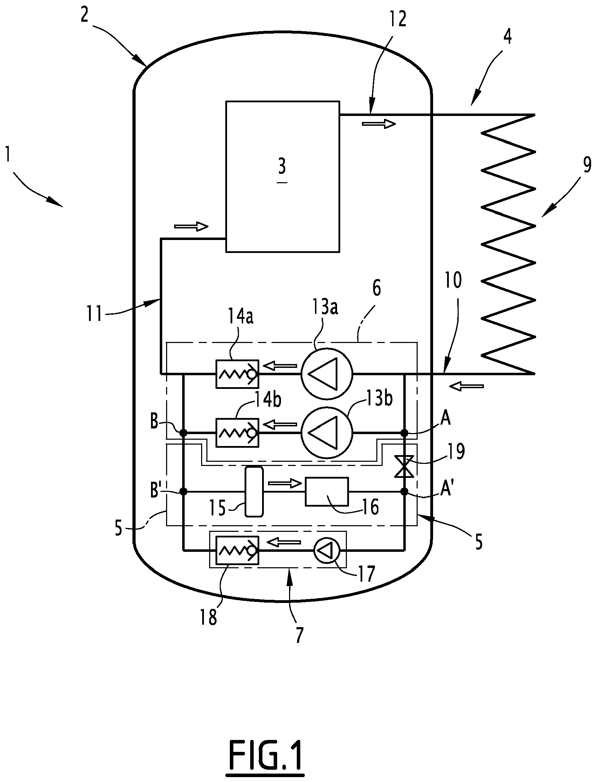

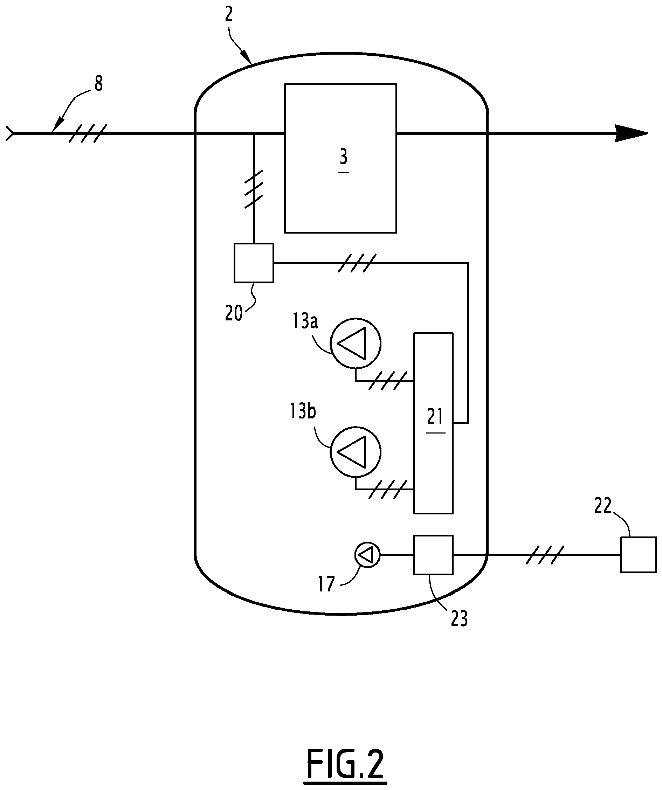

L'installation électrique 1 représentée sur les figures 1 et 2 est destinée à être immergée, notamment dans la mer. Elle comprend une enceinte 2, un équipement électrique 3, un circuit principal 4 pour le refroidissement de l'équipement électrique 3, un circuit de déionisation 5 pour déioniser l'eau du circuit principal 4, un groupe de pompage principal 6 et un groupe de pompage secondaire 7.

L'enceinte 2 est prévue pour rester étanche à l'eau dans les conditions dues à l'immersion de l'installation électrique 3.

L'équipement électrique 3 est un convertisseur de puissance, d'une puissance comprise dans la gamme allant de 50 kVA à quelques centaines de MVA. L'équipement électrique 3 est connecté électriquement à un câble électrique sous-marin 8 (représenté sur la figure 2) formant une alimentation primaire et sert à convertir la puissance apportée par cette alimentation.

Le circuit principal 4 comprend un échangeur de chaleur 9 et des conduites d'eau déionisée 10, 11 et 12. L'échangeur 9 est situé à l'extérieur de l'enceinte 2 pour réaliser un échange thermique entre l'eau déionisée et l'eau extérieure de façon à refroidir l'eau déionisée. La sortie de l'échangeur 9 est reliée hydrauliquement au groupe de pompage principal 6 par la conduite 10. La sortie du groupe de pompage principal 6 est reliée hydrauliquement par la conduite 11 à une entrée de l'équipement électrique 3. L'eau déionisée ayant circulé dans l'équipement électrique 3 est récupérée dans la conduite 12 qui la ramène à l'échangeur 9. Le groupe de pompage principal 6 est destiné à mettre en mouvement l'eau déionisée dans le circuit principal 4 et dans le circuit de déionisation 5. Le circuit principal 4 et le groupe de pompage principal 6 forment une boucle.

Le groupe de pompage principal 6 comprend un premier ensemble de pompage 13a, 14a constitué d'une pompe 13a et d'un clapet anti-retour 14a situé au refoulement de la pompe 13a. Le groupe de pompage principal comprend également un second ensemble de pompage 13b, 14b, monté en parallèle du premier ensemble de pompage et constitué, lui aussi, d'une pompe 13b et d'un clapet anti-retour 14b situé au refoulement de la pompe 13b. Le second ensemble de pompage 13b, 14b est redondant, ce qui améliore la fiabilité du groupe de pompage principal 6.

Le circuit de déionisation 5 se présente comme un circuit ouvert, monté hydrauliquement en parallèle aux bornes A et B du groupe de pompage principal 6. Ainsi, le groupe de pompage principal 6 peut mettre en mouvement l'eau déionisée dans le circuit principal 4 et dans le circuit de déionisation 5, les débits dans ces deux circuits pouvant être différents.

Le circuit de déionisation 5 comprend un déionisateur 15 et un organe 16 de contrôle du débit en série avec le déionisateur. Dans cet exemple, le déionisateur comprend une bouteille contenant une résine et l'organe de contrôle du débit est une vanne asservie à une consigne de résistivité de l'eau déionisée. Le rôle du circuit de déionisation est de maintenir un certain taux de déionisation, vérifiable par exemple par une mesure de résistivité de l'eau déionisée dans le circuit principal. Si la résistivité mesurée diminue, l'organe 16 de contrôle du débit autorise un débit plus important dans le circuit de déionisation 5 afin d'augmenter la déionisation.

Le groupe de pompage secondaire 7 comprend une pompe 17 et un clapet anti-retour 18 situé à l'aval de la pompe 17. Le groupe de pompage secondaire se présente comme un circuit ouvert, monté hydrauliquement aux bornes A' et B' d'une portion du circuit de déionisation 5 comprenant le déionisateur 15 et l'organe 16 de contrôle du débit. Un étranglement 19 est inclus dans le circuit de déionisation 5, entre les points A et A', dans une autre portion du circuit de déionisation 5 que celle aux bornes de laquelle le groupe de pompage secondaire 7 est monté. Ainsi, le groupe de pompage secondaire 7 peut assurer un débit d'eau dans le déionisateur 5 et un débit dans le circuit principal 4. L'étranglement 19 permet de régler le débit dans le circuit principal 4. Plus cet étranglement est important, plus le débit est important dans le déionisateur 15.

Sur le schéma électrique représenté sur la figure 2, les pompes 13a et 13b du groupe de pompage principal 6 sont connectées électriquement à une source de puissance principale 20, elle-même connectée au câble 8 d'alimentation de l'équipement électrique 3. Le rôle de cette source de puissance principale 20 est de mettre en forme la puissance délivrée, de 5 à 30 kVA, à un tableau 21 de distribution et de commande des pompes 13a et 13b. Lorsque l'équipement électrique 3 est alimenté, le groupe de pompage principal 6 peut donc être alimenté en électricité sans recourir à une source auxiliaire.

Le groupe de pompage secondaire 7 est connecté électriquement à une source de puissance secondaire 22, de l'ordre de 1 kVA, via un tableau de distribution électrique 23. Ainsi, le groupe de pompage secondaire 7 peut être alimenté en électricité même lorsque l'équipement électrique 3 se trouve hors tension. La source de puissance secondaire 22 est située hors de l'enceinte étanche 2. Elle est relativement peu volumineuse et, lorsqu'elle est utilisée pour alimenter le groupe de pompage secondaire 7, n'entraîne pas une consommation électrique importante. En outre, la source de puissance secondaire peut être plus facilement secourue, du fait de sa taille, que la source de puissance principale 20.

On décrira maintenant le fonctionnement de l'installation. Lorsque l'équipement électrique 3 fonctionne (mode normal), seul l'un des ensembles de pompage 13a, 14a ou 13b, 14b du groupe de pompage principal 6 est actionné. Ceci assure un débit de l'ordre de 10 à 200 m³/h dans le circuit principal 4 et de 25 à 500 l/h dans le circuit de déionisation 5. La puissance électrique de pompage provient alors uniquement de la source de puissance principale 20, la puissance étant prélevée sur le câble 8 alimentant l'équipement électrique 3.

Lorsque l'équipement électrique 3 est à l'arrêt (mode « arrêt »), seul le groupe de pompage secondaire 7 est en fonctionnement. Il assure un débit réduit dans le circuit principal 4, de l'ordre de 100 l/h à 2 m³/h, et un débit à travers le déionisateur 15 suffisant pour permettre la déionisation. Le débit pouvant être obtenu dans le déionisateur 5 est équivalent, voire supérieur, à celui existant dans le déionisateur pendant le mode normal de fonctionnement (25 à 500 l/h). L'étranglement 19 permet de contrôler le débit à travers le déionisateur 15.

Ainsi, en mode « arrêt », la puissance requise pour le pompage peut être fournie par une source de puissance 22 d'environ 1 kVA. Cette puissance est inférieure d'environ un ordre de grandeur à celle requise lorsque le groupe de pompage principal 6 doit être actionné (5 à 30 kVA). La source de puissance secondaire 22 utilisée est donc de taille réduite. La puissance consommée pour le pompage dans le mode « arrêt » est également réduite dans une proportion analogue.

Dit autrement, l'invention atteint son objectif grâce au fait que, lorsque l'équipement électrique 3 à refroidir est en fonctionnement et qu'une puissance électrique importante est requise pour actionner les pompes du groupe de pompage principal 6, celles-ci sont alimentées en puissance électrique par une source de puissance principale 20 connectée au câble 8 d'alimentation de l'équipement électrique 3 à refroidir. Lorsque, au contraire, ce dernier n'est pas en fonctionnement, un groupe de pompage secondaire 7 est utilisé pour mettre en mouvement l'eau dans le déionisateur 15 et le circuit principal 4. Le débit d'eau est alors modéré, car il a surtout pour but de maintenir un niveau de déionisation approprié. Ce débit permet aussi un échange thermique entre l'équipement électrique 3 et le milieu extérieur. Ceci s'avère utile, par exemple consécutivement à un arrêt brutal de l'équipement électrique 3, la source de puissance secondaire 22 étant éventuellement secourue, pour assurer l'évacuation de la chaleur résiduelle de l'équipement électrique 3.

Par conséquent, le groupe de pompage secondaire 7 peut être alimenté par une source de puissance secondaire 22 de plus petite taille que celle requise pour le groupe de pompage principal 6, de l'ordre de 1 kVA. Ceci correspond à une réduction d'environ un ordre de grandeur. La puissance consommée par le système de refroidissement pendant le mode « arrêt » est également réduite dans une proportion analogue.

Selon un autre mode de réalisation, non représenté, le circuit de déionisation 5 peut être en série avec le groupe de pompage principal 6. Le branchement en parallèle illustré par la figure 1 présente toutefois l'avantage que le débit dans le déionisateur 15 peut être différent du débit dans le circuit principal 4.

Selon un autre mode de réalisation, l'étranglement 19 peut être placé, dans le circuit de déionisation 5, de l'autre côté par rapport au déionisateur 15, entre les points B et B'. Il peut également être placé dans le circuit principal 4, mais cela présente le désavantage de créer une perte de charge à vaincre par le groupe de pompage principal 6, d'où une perte d'énergie en mode « normal » de fonctionnement.

Selon un mode de réalisation (non-représenté), la source de puissance principale 20 connectée au câble 8 d'alimentation est secourue. Ceci permet de continuer à utiliser la source de puissance principale pour l'alimentation du groupe de pompage principal 6, même lorsque l'équipement électrique 3 n'est pas alimenté par le câble 8.

Selon un mode de réalisation alternatif (non-représenté), la source de puissance principale 20 est une source de puissance autonome, non connectée au câble 8 d'alimentation. Ceci permet également de continuer à utiliser la source de puissance principale pour l'alimentation du groupe de pompage principal 6, même lorsque l'équipement électrique 3 n'est pas alimenté.

Continuer à utiliser le groupe de pompage principal 6, alors que l'équipement électrique 3 est à l'arrêt, présente un intérêt pour refroidir l'équipement électrique 3, par exemple après un arrêt brutal, alors qu'une chaleur importante doit être évacuée.

## Revendications

1. Système de refroidissement à eau déionisée pour équipement électrique (3), l'équipement électrique (3) étant connecté électriquement à une alimentation primaire (8), comprenant :
- un circuit principal (4) pour canaliser et refroidir l'eau déionisée destinée à circuler dans l'équipement électrique (3) ;
- un groupe de pompage principal (6) pour faire circuler l'eau déionisée dans le circuit principal (4) ;
- une source de puissance principale (20) pour alimenter le groupe de pompage principal (6) ; et
- un circuit de déionisation (5) relié à deux points du circuit principal (4) pour déioniser l'eau du circuit principal, le circuit de déionisation (5) comprenant un déionisateur (15) ;
**caractérisé en ce qu'**il comprend en outre :
- un groupe de pompage secondaire (7) pour faire circuler l'eau déionisée dans le déionisateur (15) ; et
- une source de puissance secondaire (22) pour alimenter le groupe de pompage secondaire (7) ;
la source de puissance secondaire (22) étant moins puissante que la source de puissance principale (20).

2. Système de refroidissement à eau déionisée selon la revendication 1, **caractérisé en ce que** :
- le circuit de déionisation (5) est monté hydrauliquement aux bornes du groupe de pompage principal (6) ; et
- le groupe de pompage secondaire (7) est monté hydrauliquement aux bornes d'une portion du circuit de déionisation (5) comprenant le déionisateur (15).

3. Système de refroidissement à eau déionisée selon la revendication 1 ou 2, **caractérisé en ce qu'**il comprend en outre des éléments (14a, 14b, 16, 18, 19) pour créer des pertes de charge hydrauliques, les éléments étant agencés de telle manière que, lorsque le groupe de pompage principal (6) est à l'arrêt et que le groupe de pompage secondaire (7) fonctionne, le groupe de pompage secondaire (7) fait circuler un premier débit d'eau déionisée dans le circuit principal (4) et un second débit d'eau déionisée dans le déionisateur (15).

4. Système de refroidissement à eau déionisée selon la revendication 3, **caractérisé en ce que** les éléments (14a, 14b, 16, 18, 19) pour créer des pertes de charge hydrauliques comprennent un ou plusieurs clapets anti-retour (14a, 14b) situés dans le groupe de pompage principal (6) et un étranglement (19) situé dans le circuit de déionisation (5) à l'extérieur de la portion du circuit de déionisation (5) aux bornes de laquelle le groupe de pompage secondaire (7) est monté.

5. Installation électrique (1) **caractérisée en ce qu'**elle comprend :
- un équipement électrique (3) destiné à être alimenté en puissance électrique par une alimentation primaire (8) ; et
- un système de refroidissement à eau déionisée selon l'une quelconque des revendications précédentes pour refroidir l'équipement électrique (3).

6. Installation électrique (1) selon la revendication 5, **caractérisée en ce que** la source de puissance principale (20) est connectée à l'alimentation primaire (8) de l'équipement électrique (3).

7. Installation électrique (1) selon la revendication 5 ou 6, **caractérisée en ce qu'**elle comprend en outre une enceinte (2) étanche à l'eau, l'enceinte abritant l'équipement électrique (3), le groupe de pompage principal (6), le circuit de déionisation (5) et le groupe de pompage secondaire (7).

8. Installation électrique (1) selon l'une quelconque des revendications 5 à 7, **caractérisée en ce que** la source de puissance secondaire (22) est située à l'extérieur de l'enceinte (2).

9. Installation électrique (1) selon l'une quelconque des revendications 5 à 8, **caractérisée en ce qu'**elle est sous-marine.

10. Installation électrique (1) selon l'une quelconque des revendications 5 à 9, **caractérisée en ce que** l'équipement électrique (3) est un convertisseur électronique de puissance.

11. Procédé de refroidissement d'une installation électrique (1) selon l'une quelconque des revendications 5 à 10, **caractérisé en ce qu'**il comprend les étapes suivantes :
- l'équipement électrique (3) étant en fonctionnement, alimentation en puissance électrique du groupe de pompage principal (6) du système de refroidissement par la source de puissance principale (20) de manière à faire circuler l'eau déionisée dans le circuit principal (4) et le circuit de déionisation (5) du système de refroidissement ; et
- l'équipement électrique (3) étant à l'arrêt, alimentation en puissance électrique du groupe de pompage secondaire (7) du système de refroidissement par la source de puissance secondaire (22) pour faire circuler l'eau déionisée dans au moins une portion du circuit de déionisation (5) comprenant le déionisateur (15) et dans le circuit principal (4).

12. Procédé de refroidissement d'une installation électrique selon la revendication 11, **caractérisé en ce que** :
- à l'étape d'alimentation en puissance électrique du groupe de pompage principal (6), le groupe de pompage secondaire (7) est à l'arrêt ; et
- à l'étape d'alimentation en puissance électrique du groupe de pompage secondaire (7), le groupe de pompage principal (6) est à l'arrêt.

## Patentansprüche

1. Kühlsystem mit deionisiertem Wasser für eine elektrische Ausrüstung (3), wobei die elektrische Ausrüstung (3) mit einer primären Versorgung (8) elektrisch verbunden ist, aufweisend:
- einen Hauptkreislauf (4) zur Leitung und Kühlung des deionisierten Wassers, das dazu bestimmt ist, in der elektrischen Ausrüstung (3) zu zirkulieren;
- eine Hauptpumpengruppe (6), um das deionisierte Wasser in dem Hauptkreislauf (4) zirkulieren zu lassen;
- eine Hauptenergiequelle (20) zur Speisung der Hauptpumpengruppe (6); und
- einen Deionisationskreislauf (5), der mit zwei Stellen des Hauptkreislaufs (4) verbunden ist, um das Wasser des Hauptkreislaufs zu deionisieren, wobei der Deionisationskreislauf (5) einen Deionisator (15) aufweist;
**dadurch gekennzeichnet, dass** es ferner aufweist:
- eine sekundäre Pumpengruppe (7), um das deionisierte Wasser in dem Deionisator (15) zirkulieren zu lassen; und
- eine sekundäre Energiequelle (22) zur Speisung der sekundären Pumpengruppe (7);
wobei die sekundäre Energiequelle (22) weniger leistungsstark als die Hauptenergiequelle (20) ist.

2. Kühlsystem mit deionisiertem Wasser nach Anspruch 1, **dadurch gekennzeichnet, dass**:
- der Deionisationskreislauf (5) an Anschlüssen der Hauptpumpengruppe (6) hydraulisch montiert ist; und
- die sekundäre Pumpengruppe (7) an Anschlüssen eines Abschnitts des Deionisationskreislaufs (5), der den Deionisator (15) aufweist, hydraulisch montiert ist.

3. Kühlsystem mit deionisiertem Wasser nach Anspruch 1 oder 2, **dadurch gekennzeichnet, dass** es ferner Elemente (14a, 14b, 16, 18, 19) zur Erzeugung hydraulischer Druckverluste aufweist, wobei die Elemente derart angeordnet sind, dass, wenn sich die Hauptpumpengruppe (6) im Stillstand befindet und die sekundäre Pumpengruppe (7) betrieben wird, die sekundäre Pumpengruppe (7) eine erste Durchflussmenge des deionisierten Wassers in dem Hauptkreislauf (4) und eine zweite Durchflussmenge des deionisierten Wassers in dem Deionisator (15) zirkulieren lässt.

4. Kühlsystem mit deionisiertem Wasser nach Anspruch 3, **dadurch gekennzeichnet, dass** die Elemente (14a, 14b, 16, 18, 19) zur Erzeugung hydraulischer Druckverluste ein oder mehrere Rückschlagventile (14a, 14b), die sich in der Hauptpumpengruppe (6) befinden, und eine Drossel (19) aufweisen, die sich in dem Deionisationskreislauf (5) außerhalb des Abschnitts des Deionisationskreislaufs (5) befindet, an dessen Anschlüssen die sekundäre Pumpengruppe (7) montiert ist.

5. Elektrische Anlage (1), **dadurch gekennzeichnet, dass** sie aufweist:
- eine elektrische Ausrüstung (3), das dazu bestimmt ist, durch die Hauptversorgung (8) mit elektrischer Energie versorgt zu werden; und
- ein Kühlsystem mit deionisiertem Wasser nach einem beliebigen der vorhergehenden Ansprüche zur Kühlung der elektrischen Ausrüstung (3).

6. Elektrische Anlage (1) nach Anspruch 5, **dadurch gekennzeichnet, dass** die Hauptenergiequelle (20) mit der Hauptversorgung (8) der elektrischen Ausrüstung (3) verbunden ist.

7. Elektrische Anlage (1) nach Anspruch 5 oder 6, **dadurch gekennzeichnet, dass** sie ferner einen wasserdichten Raum (2) aufweist, wobei der Raum die elektrische Ausrüstung (3), die Hauptpumpengruppe (6), den Deionisationskreislauf (5) und die sekundäre Pumpengruppe (7) aufnimmt.

8. Elektrische Anlage (1) nach einem beliebigen der Ansprüche 5 bis 7, **dadurch gekennzeichnet, dass** die sekundäre Energiequelle (22) sich außerhalb des Raumes (2) befindet.

9. Elektrische Anlage (1) nach einem beliebigen der Ansprüche 5 bis 8, **dadurch gekennzeichnet, dass** sie sich unter Wasser befindet.

10. Elektrische Anlage (1) nach einem beliebigen der Ansprüche 5 bis 9, **dadurch gekennzeichnet, dass** die elektrische Ausrüstung (3) ein elektronischer Leistungswandler ist.

11. Verfahren zum Kühlen einer elektrischen Anlage (1) nach einem beliebigen der Ansprüche 5 bis 10, **dadurch gekennzeichnet, dass** es die folgenden Schritte aufweist:
- wenn sich die elektrische Ausrüstung (3) im Betrieb befindet, Versorgen der Hauptpumpengruppe (6) des Kühlsystems mit elektrischer Energie durch die Hauptenergiequelle (20) in einer Weise, um das deionisierte Wasser in dem Hauptkreislauf (4) und dem Deionisationskreislauf (5) des Kühlsystems zirkulieren zu lassen; und
- wenn sich die elektrische Ausrüstung (3) im Stillstand befindet, Versorgen der sekundären Pumpengruppe (7) des Kühlsystems mit elektrischer Energie durch die sekundäre Energiequelle (22), um das deionisierte Wasser in wenigstens einem Abschnitt des Deionisationskreislaufs (5), der den Deionisator (15) aufweist, und in dem Hauptkreislauf (4) zirkulieren zu lassen.

12. Verfahren zum Kühlen einer elektrischen Anlage nach Anspruch 11, **dadurch gekennzeichnet, dass**:
- in dem Schritt des Versorgens der Hauptpumpengruppe (6) mit elektrischer Energie die sekundäre Pumpengruppe (7) sich im Stillstand befindet; und
- in dem Schritt des Versorgens der sekundären Pumpengruppe (7) mit elektrischer Energie die Hauptpumpengruppe (6) sich im Stillstand befindet.

## Claims

1. Cooling system with deionised water for electrical equipment (3), wherein the electrical equipment (3) is electrically connected to a primary supply (8), comprising:
- a main circuit (4) for directing and cooling the deionised water to be circulated in the electrical equipment (3);
- a main pumping group (6) for circulating the deionised water in the main circuit (4);
- a main power source (20) for supplying power to the main pumping group (6); and
- a deionisation circuit (5) connected to two points of the main circuit (4) for deionising the water of the main circuit, the deionisation circuit (5) comprising a deioniser (15);
**characterised in that** it also comprises
- a secondary pumping group (7) for circulating the deionised water in the deioniser (15); and
- a secondary power source (22) for supplying power to the secondary pumping group (7);
the secondary power source (22) being less powerful than the main power source (20).

2. The cooling system with deionised water according to claim 1, **characterised in that**:
- the deionisation circuit (5) is hydraulically attached to the terminals of the main pumping group (6); and
- the secondary pumping group (6) is hydraulically attached to the terminals of a part of the deionisation circuit (5) comprising the deioniser (15).

3. The cooling system with deionised water according to claim 1 or 2, **characterised in that** it also comprises elements (14a, 14b, 16, 18, 19) for creating hydraulic load losses, wherein the elements are arranged such that, when the main pumping group (6) is not in operation and the secondary pumping group (7) is in operation, the secondary pumping group (7) circulates a first flow of deionised water in the main circuit (4) and a second flow of deionised water in the deioniser (15).

4. The cooling system with deionised water according to claim 3, **characterised in that** the elements (14a, 14b, 16, 18, 19) for creating hydraulic load losses comprise one or more non-return valves (14a, 14b) situated in the main pumping group (6), and a choke (19) situated in the deionisation circuit (5) outside the part of the deionisation circuit (5) at which the secondary pumping group (7) is attached to the terminals.

5. Electrical installation (1), **characterised in that** it comprises:
- an electrical equipment (3) intended to be supplied with electrical power by a primary supply (8); and
- a cooling system with deionised water according to any of the preceding claims, for cooling the electrical equipment (3).

6. Electrical installation (1) according to claim 5, **characterised in that** the main power source (20) is connected to the primary supply (8) of the electrical equipment (3).

7. Electrical installation (1) according to claim 5 or 6, **characterised in that** it also comprises a water-tight enclosure (2), the enclosure housing the electrical equipment (3), the main pumping group (6), the deionisation circuit (5) and the secondary pumping group (7).

8. Electrical installation (1) according to any of claims 5 to 7, **characterised in that** the secondary power source (22) is situated outside the enclosure (2).

9. Electrical installation (1) according to any of claims 5 to 8, **characterised in that** it is an underwater installation.

10. Electrical installation (1) according to any of claims 5 to 9, **characterised in that** the electrical equipment (3) is an electronic power converter.

11. Method for cooling an electrical installation (1) according to any of claims 5 to 10, **characterised in that** it comprises the following steps:
- with the electrical equipment (3) in operation, supplying electrical power to the main pumping group (6) of the cooling system from the main power source (20) so as to cause the circulation of deionised water in the main circuit (4) and the deionisation circuit (5) of the cooling system; and
- with the electrical equipment (3) not in operation, supplying electrical power to the secondary pumping group (7) of the cooling system from the secondary power source (22) so as to cause the circulation of deionised water in at least a part of the deionisation circuit (5) comprising the deioniser (15) and in the main circuit (4).

12. Method for cooling an electrical installation according to claim 11, **characterised in that**:
- at the step of supplying electrical power to the main pumping group (6), the secondary pumping group (7) is not in operation; and
- at the step of supplying electrical power to the secondary pumping group (7), the main pumping group (6) is not in operation.
